# EUROPÄISCHE PATENTSCHRIFT

(11) **EP 1 678 756 B1**
(45) Veröffentlichungstag und Bekanntmachung des Hinweises auf die Patenterteilung: **01.12.2010**
(21) Anmeldenummer: 04790042.8
(22) Anmeldetag: 25.10.2004
(51) Int. Cl.: H01L 23/31

(54) **HALBLEITERBAUTEIL MIT GEHÄUSEKUNSTSTOFFMASSE, HALBLEITERCHIP UND SCHALTUNGSTRÄGER SOWIE VERFAHREN ZUR HERSTELLUNG DESSELBEN**
SEMICONDUCTOR COMPONENT COMPRISING SYNTHETIC HOUSING MATERIAL, SEMICONDUCTOR CHIP AND CIRCUIT SUPPORT, AND METHOD FOR PRODUCING THE SAME
COMPOSANT A SEMICONDUCTEUR COMPORTANT UN MATERIAU DE BOITIER CONSTITUE D'UNE MATIERE PLASTIQUE, UNE PUCE A SEMICONDUCTEUR ET UN SUPPORT DE CIRCUIT, ET PROCEDE DE PRODUCTION DUDIT COMPOSANT

(30) Priorität: 27.10.2003 DE 10350239
(43) Veröffentlichungstag der Anmeldung: 12.07.2006
(73) Patentinhaber: Infineon Technologies AG, 85579 Neubiberg (DE)
(72) Erfinder: HETZEL, Wolfgang, 89564 Nattheim (DE); THOMAS, Jochen, 81827 München (DE)
(74) Vertreter: Patentanwaltskanzlei WILHELM & BECK
(86) Internationale Anmeldenummer: PCT/DE2004/002374
(87) Internationale Veröffentlichungsnummer: WO 2005/045926

(56) Entgegenhaltungen:
- TW-A- 554 501
- US-A- 5 874 784
- US-A1- 2002 045 294
- US-A1- 2002 056 561
- US-B1- 6 429 372

## Beschreibung

Die Erfindung betrifft ein Halbleiterbauteil mit Gehäusekunststoffmasse. Der Halbleiterchip ist in die Gehäusekunststoffmasse mit einer seiner Oberseiten und seinen Randseiten eingebettet. Die andere Oberseite des Halbleiterchips ist auf dem Schaltungsträger angeordnet. Die nicht von dem Halbleiterchip bedeckte Oberseite des Schaltungsträgers ist von der Gehäusekunststoffmasse bedeckt.

Ein derartiger Aufbau eines Halbleiterbauteils wird durch die fixierende Kunststoffgehäusemässe, die gleichzeitig den Halbleiterchip einbettet und auf dem Schaltungsträger fest verankert ist, zusammengehalten. Der Halbleiterchip ist zusätzlich über eine Klebstofflage auf dem Schaltungsträger in seiner Position fixiert, wobei die Klebstofflage dafür sorgt, dass sich der Halbleiterchip beim Aufbringen der Gehäusekunststoffmasse weder verschiebt, noch von dem Schaltungsträger abhebt. Gleichzeitig wirkt die Klebstofflage unter dem Halbleiterchip als Spannungsausgleichsschicht beim Auftreten thermischer Spannungen.

Jedoch kommt die eigentlich ausgleichende Wirkung der Klebstofflage unter dem Halbleiterchip nicht voll zur Geltung, da sie auf allen Seiten von der starren Gehäusekunststoffmasse umschlossen ist. Damit ist auch die auf die Fläche des Halbleiterchips begrenzte Klebstofflage seitlich fixiert und kann den Spannungsunterschied zwischen Schaltungsträger und Halbleiterchip, der durch die unterschiedlichen Ausdehnungskoeffizienten verursacht wird, nicht vollständig ausgleichen. Somit wird bei Temperaturzyklusprüfungen nahezu die gesamte Spannung zwischen Halbleiterchip und Schaltungssubstrat an die Außenkontakte des Halbleiterbauteils weitergegeben, was zu erheblichen Ausfällen führen kann.

Trotz des Ausgleichs thermischer Spannungen durch die Klebstofflage zwischen Halbleiterchip und Schaltungsträger, können außerdem bei einem derartigen Aufbau eines Halbleiterbauteils Mikrorisse auftreten, insbesondere an der Grenzschicht zwischen Gehäusekunststoffmasse und Schaltungsträgeroberseiten. Bisher wurde versucht durch Verstärkung der Verankerungen zwischen beiden Materialien derartige Mikrorisse, die im Extremfall bis zur Delamination führen können, zu unterbinden. Dazu wurden poröse keramische oder metallische Beschichtungen für die Oberseite des Schaltungsträgers entwickelt und auf dem Schaltungsträger abgeschieden, um die Verankerung mit der Gehäusekunststoffmasse zu verbessern. Dennoch wird beobachtet, dass die stärkere Verankerung dazu führt, dass sich die Mikrorissbildung in Bereiche oberhalb der Verankerungsschicht verlagert, jedoch nicht vollständig unterdrückt werden kann.

Halbleiterbauteile mit einem Gehäusekunststoffteil sind aus der US 2002/056561 A1, der US-B1-6,429,372 und der TW 554501 B bekannt.

Aufgabe der Erfindung ist es, ein Halbleiterbauteil mit Gehäusekunststoffmasse zu schaffen, das die Probleme gegenwärtiger Halbleiterbauteile im Übergangsbereich von dem Schaltungsträger auf die Gehäusekunststoffmasse und im Übergang auf das Halbleiterchipmaterial löst und eine verbesserte Ausbeute nach einer Temperaturzyklusprüfung ermöglicht.

Gelöst Ansprüche wird die obige Aufgabe durch den Gegenstand der unabhängigen.

Erfindungsgemäß wird ein Halbleiterbauteil mit Gehäusekunststoffmasse, Halbleiterchip und Schaltungsträger geschaffen, bei dem der Halbleiterchip in der Gehäusekunststoffmasse mit einer seiner beiden Oberseiten und seiner Randseite eingebettet ist. Die andere der beiden Oberseiten ist auf einer Oberseite des Schaltungsträgers oberflächenmontiert. Der nicht von dem Halbleiterchip bedeckte Bereich der Oberseite des Schaltungsträgers ist von der Kunststoffgehäusemasse bedeckt. Zwischen Gehäusekunststoffmasse und Schaltungsträger, sowie zwischen Halbleiterchip und Schaltungsträger ist auf der Oberseite des Schaltungsträgers eine durchgängige, elastische Klebstofflage angeordnet.

Bei dem erfindungsgemäßen Halbleiterbauteil wird somit keine intensive Verankerung der Kunststoffgehäusemasse mit eingebettetem Halbleiterchip auf dem Schaltungsträger angestrebt, sondern es werden vielmehr die beiden Bereiche durch die dazwischen angeordnete durchgängige elastische Klebstofflage entkoppelt. Bei Temperaturzyklusprüfungen hat sich bei Bauteilen herkömmlicher Art herausgestellt, dass die Grenzschicht zwischen diesen, sich unterschiedlich ausdehnenden Bereichen der Gehäusekunststoffmasse mit Halbleiterchip und des Schaltungsträgers extrem belastet werden und zur Bildung von Mikrorissen neigen, was mit dem erfindungsgemäßen Bauteil überwunden ist. Diese Mikrorisse führen im Extremfall zur Delamination, nicht jedoch bei dem erfindungsgemäßen Bauteil. Zumindest wird das Eindringen von Feuchtigkeit in die Mikrorisse bei hoher Temperatur bei herkömmlichen Bauteilen gefördert, wobei dann die eingedrungene Feuchtigkeit bei den extremen Kühltemperaturen des Temperaturzyklustests das Bauteil sprengen können, was bei dem erfindungsgemäßen Bauteil durch die Klebstofflage unterbunden wird.

Der Vorteil des erfindungsgemäßen Halbleiterbauteils ist es, dass im Gegensatz zu der Tendenz die Verankerung zwischen den unterschiedlichen Materialien zu verstärken und die mechanische Kopplung stetig zu verbessern und die Starrheit des Bauteils zu erhöhen, bei dem erfindungsgemäßen Halbleiterbauteil die Verankerung bzw. die Ankopplung der Oberseite des Schaltungsträgers mit der Gehäusekunststoffmasse gelockert wird, bzw. durch eine gummielastische Klebstofflage vollständig aufgehoben wird.

Somit wird bei dem erfindungsgemäßen Halbleiterbauteil eine Entkopplung des Ausdehnungsverhaltens der Komponenten auf der Oberseite des Schaltungsträgers von dem Material des Schaltungsträgers geschaffen, was zur Verminderung der Mikrorissbildung und zur Vermeidung der Delaminationsgefahr führt. Von besonderem Vorteil ist es, wenn eine Klebstofflage auf der Basis von Elastomeren auf der Oberseite des Schaltungsträgers angeordnet wird, da derartige Elastomere eine hohe Differenz in dem Ausdehnungsverhalten der Materialien tolerieren können, ohne dass sich Mikrorisse bilden oder eine Delamination auftritt. Auch Klebstoffgel ist ein erfolgreich anzuwendende Mittel, um eine derartige Klebstofflage zu verwirklichen. Dabei und von herausragender Bedeutung Elastomere auf Silikonbasis.

Es ist es vorgesehen, dass die Randbereiche des Halbleiterbauteils frei von der elastischen Klebstofflage sind. Dieser Bereich, der frei von elastischer Kunststofflage ist, wird in seinem Flächenbedarf so minimal wie möglich gehalten und umgibt den gesamten Bauteilrand.

Hiermit ist der Vorteil verbunden, dass die Klebstoffmasse der Klebstofflage beim Singulieren bzw. Vereinzeln von Halbleiterbauteilen aus einem Nutzen, nicht zur Verschmutzung der Trennwerkzeuge führt. Zumal Klebstoffmassen an den Trennwerkzeugen zu erheblichen Fertigungsproblemen führen können, was für den Einsatz in einer Massenproduktion nicht zulässig ist. Somit hat das Freihalten der Randbereiche des Halbleiterbauteils von der elastischen Klebstofflage einen nicht geringen Fertigungsvorteil. Jedoch kann dieses Freihalten dazu führen, dass verstärkt in den Randbereichen nun Mikrorisse in der Kunststoffgehäusemasse auftreten, die nun in den Randbereichen auf dem Schaltungsträger ohne entkoppelnde elastische Klebstofflage aufliegt.

Die Erfindung sieht vor, dass die von Klebstofflage freigehaltenen Randbereiche des Halbleiterbauteils elastische Metalllagen aufweisen. Derartige Metalllagen können so aufeinander abgestimmt sein, dass ein Spannungsabbau in ihnen erfolgt, ohne zu einer Mikrorissbildung zu führen. Dazu kann auf dem Schaltungsträger eine Kupferlage angeordnet sein, die eine Kupferlegierung aufweist und darauf kann im Randbereich eine Goldlage einer Goldlegierung abgeschieden sein, wobei elastische Verformungen dieser Weichmetalle dem Abbau von Spannungen dienen, ohne dass Mikrorissbildungen auftreten. Ferner ist die Verankerung der Gehäusekunststoffmasse auf einer Goldbeschichtung minimal, so dass neben einer duktilen Verschiebung auch eine gezielte Mikrospaltbildung auftreten kann, die jedoch dann keine Mikrorisse in der Gehäusekunststoffmasse verursacht.

Anstelle einer Goldlage können auch Silber oder Aluminiumlagen auf der Kupferlage abgeschieden sein, da auch diese Metalle Legierungen aufweisen, die äußerst duktil sind und somit bei einer Spannungsbelastung duktil nachgeben können, ohne Mikrorisse zu bilden. Dazu kann die Breite der Metalllagen in den Randbereichen des Halbleiterbauteils an die Breite von Sägespuren in der Weise angepasst sein, dass bei der Herstellung der Randseiten des Halbleiterbauteils die elastische Klebstofflage nicht dem Sägevorgang ausgesetzt ist. Das Verhältnis zwischen der Breite der Metalllage und der Breite der Sägespuren liegt dazu vorzugsweise zwischen 1,2 und 3. Dabei wird die Justagetoleranz beim Ausrichten für den Sägevorgang und die Sägetoleranz berücksichtigt, um das Verhältnis zwischen der Breite der Metalllagen und der Breite der Sägespuren genauer zu bestimmen.

Ein Nebenaspekt betrifft einen Nutzen, der in Zeilen und Spalten angeordnete Bauteilpositionen mit Halbleierbauteilen aufweist, wie sie oben beschrieben wurden. Ein derartiger Nutzen ist praktisch eine Verbundplatte aus der Gehäusekunststoffmasse, den Halbleiterchips und dem Schaltungsträger, die in mehreren Bauteilpositionen angeordnete Halbleiterbauteile aufweist. Ein derartiger Nutzen kann in seiner Form eine rechteckige Platte darstellen oder einem Halbleiterwafer nachgebildet sein, so dass für das Trennen herkömmliche Trennautomaten für das Wafertrennen eingesetzt werden können.

Ein Verfahren zur Herstellung eines derartigen Nutzens mit Gehäusekunststoffmasse, Halbleiterchips und Schaltungsträger in mehreren Halbleiterbauteilpositionen, weist die nachfolgenden Verfahrensschritte auf. Zunächst wird ein Schaltungsträger mit in Zeilen und/oder Spalten angeordneten Bauteilpositionen hergestellt. Ein derartiger Schaltungsträger kann aus einer isolierenden Kunststoffplatte bestehen, die auf der Schaltungsträgerunterseite eine Umverdrahtungsstruktur aufweist, welche ihrerseits Umverdrahtungsleitungen und Außenkontaktflächen besitzt.

Die Umverdrahtungsleitungen führen dabei zu Bondfingern, die am Rand einer zentralen Öffnung in dem Schaltungsträger angeordnet sind. Diese zentrale Öffnung ermöglicht einen Zugriff auf Kontaktflächen eines Halbleiterbauteils, das nach dieser Öffnung ausgerichtet ist. Jedoch noch bevor ein derartiger Halbleiterchip auf die Öffnung aufgebracht ist, wird eine elastische Klebstofflage, die sowohl den Bereich des vorgesehenen Halbleiterchips, als auch den Bereich der vorgesehenen Gehäusekunststoffmasse auf einer Oberseite des Schaltungsträgers in die Bauteilpositionen abdeckt. Anschließend werden Halbleiterchips auf die Klebstofflage in den Bauteilpositionen ausgerichtet und aufgeklebt.

Für den Fall, dass das Schaltungssubstrat eine zentrale Öffnung aufweist, wird beim Aufkleben des Halbleiterchips darauf geachtet, dass Kontaktflächen der aktiven Oberseite des Halbleiterchips, welche in Bondkanälen angeordnet sind, entsprechend der Öffnung in dem Schaltungsträger in den Bauteilpositionen ausgerichtet werden.

Anschließend werden elektrische Verbindungen zwischen Kontaktflächen des Halbleiterchips und dem Schaltungsträger in den Bauteilpositionen hergestellt. Im Falle eines zentralen Bondkanals können die Kontaktflächen, die beispielsweise zweireihig in dem zentralen Bondkanal angeordnet sind, über Bonddrähte mit den Bondfingern der Umverdrahtungsstruktur auf der Unterseite des Schaltungsträgers verbunden werden. Anschließend wird eine Gehäusekunststoffmasse auf die Klebstofflage unter Einbetten der Halbleiterchips und unter Ausbilden eines Nutzens mit mehreren Halbleiterbauteilpositionen aufgebracht. Im Falle einer Bondkanalöffnung auf der Rückseite des Schaltungsträgers kann auch diese, beim Aufbringen einer Gehäusekunststoffmasse, versiegelt werden.

Dieses Verfahren hat den Vorteil, dass parallel für mehrere Halbleiterbauteilpositionen gleichzeitig einzelne Verfahrensschritte durchgeführt werden können. Darüber hinaus hat das Verfahren den Vorteil, dass mit diesem Verfahren ein Nutzen geschaffen wird, dessen oberer Bereich, nämlich der Bereich der Kunststoffgehäusemasse und der Halbleiterchips, von dessen unterem Bereich, dem Schaltungsträger mit Bondverbindungen in dem jeweiligen Ausdehnungsverhalten entkoppelt ist.

Zur Herstellung eines Halbleiterbauteils ist lediglich der Nutzen entlang der Trennspuren oder Sägespuren auf einzelnen Halbleiterbauteilen aufzutrennen, wobei diese Halbleiterbauteile noch keine Außenkontakte aufweisen. Die Außenkontakte können, sowohl vor dem Auftrennen des Nutzens, als auch nach dem Auftrennen des Nutzens auf die jeweiligen Außenkontaktflächen der Umverdrahtungsstruktur auf die Unterseite des Schaltungsträgers aufgebracht werden.

Werden die Außenkontakte vor dem Auftrennen des Nutzens aufgebracht, hat dieses den Vorteil, dass auch die Außenkontakte in einem Verfahrensschritt gleichzeitig für mehrere Halbleiterbauteile auf die Außenkontaktflächen aufgebracht und mit den Außenkontaktflächen verbunden werden können. Bei einem Verfahren, bei dem vorgesehen ist, erst in jeder Bauteilposition die Bauteile zu trennen und anschließend Außenkontakte auf Außenkontaktflächen aufzubringen, ergibt sich der Vorteil, dass nur auf die Halbleiterbauteile Außenkontakte aufzubringen sind, die vorher beim Funktionstest des Nutzens nicht als defekte Bauteile markiert wurden.

In einem weiteren Durchführungsbeispiel des Verfahrens ist es vorgesehen, dass vor dem Aufbringen der Klebstofflage ein Muster von Metalllagen auf den Schaltungsträger aufgebracht wird. Dieses Muster bedeckt einerseits die Sägespuren mit den Metalllagen und andererseits die Randbereiche jeder Bauteilpositionen. Dabei liegt die Breite der Metalllagen, im Verhältnis zur Breite der Sägespuren zwischen etwa 1, 2 bis 3. Dieses Verhältnis kann genau an die Toleranzen der Sägespurbreiten und den Toleranzen der Ausrichtungsmöglichkeit des Nutzens in der Vorbereitung des Sägens angepasst werden. Sind die Toleranzen relativ eng, so kann auf die minimale Breite von 1, 2 im Verhältnis zur Sägespurenbreite zurückgegangen werden und sind die Toleranzen entsprechend hoch, so können Breiten bis zum dreifachen der Sägespurbreite vorgesehen werden.

Diese Metalllagen haben einerseits den Vorteil, dass sie den thermischen Dehnungen der Komponenten des Halbleiterbauteils folgen können und sich dabei duktil verändern, ohne Mikrorisse zu bilden oder Mikrospalten in einem gewollten Randbereich auszulösen. Des weiteren hat das Aufbringen der Metalllagen den Vorteil, dass Sägewerkzeuge nicht durch das gummielastische Material der Klebstofflage verunreinigt werden und somit in längere Wartungsintervalle überstehen, was die Fertigungskosten erheblich entlastet.

Zusammenfassend ist festzustellen, dass mit der Grundidee die Klebstofflage bis zum Verpackungsrand auszudehnen, bzw. maximal bis zur Singulationstoleranz einer Sägespur zu führen, der Vorteil verbunden ist, dass die Thermospannungen abbauende, elastische Klebstofflage nicht mehr durch die Gehäusekunststoffmasse in ihrem Ausdehnungsverhalten eingeschränkt wird. Wird z.B. zusätzlich in den Randbereichen des Halbleiterbauteils in die Grenzschicht eine Goldschicht eingebracht, so wird ebenfalls der Bereich der Gehäusekunststoffmasse mit dem Halbleiterchip mechanisch von dem Schaltungsträger entkoppelt. Zumal eine Goldschicht eine niedrigere Haftung zu der Kunststoffgehäusemasse aufweist, als die sonst üblichen Lötstopmasken oder Verankerungsbeschichtungen herkömmlicher Bauteile.

Es kann somit ein vollständiger Pfad zur Entkopplung zwischen dem Halbleiterchip und in der Kunststoffgehäusemasse dem Schaltungsträger durch die nachfolgende erfindungsgemäße Maßnahme erreicht werden: 1.

Es wird an der Schaltungsträgeroberseite im Randbereich ein Goldrand platziert, der auf eine Kupferschicht oder auf eine Lotschicht aufgebracht ist, die ohnehin bei der Herstellung des Schaltungsträgers vorhanden sind. Da auf dem Gold die Gehäusekunststoffmasse schlecht haftet, ergeben sich lokale Stellen reduzierter Haftung und somit ein gewollter Spalt zwischen Goldschicht und Gehäusekunststoffmasse.

Somit sind durch diese Erfindung der Halbleiterchip mit Gehäusekunststoffmasse nahezu vollständig von dem Schaltungsträger entkoppelt, wobei die unterschiedlichen Ausdehnungen, aufgrund unterschiedlicher Ausdehnungskoeffizienten von der Klebstofflage aufgefangen werden. Weil der Klebstoff nicht vollständig bis zum Rand des Halbleiterbauteils ausdehnt, wird darüber hinaus der Singulationsvorgang, d.h. die Sägetechnik nicht beeinträchtigt.

Der sich in der Grenzfläche zwischen Goldlage und Gehäusekunststoffmasse eventuell ausbildende Spalt kann gleichzeitig als Feuchtepfad dienen, so dass sich die mechanische Entkoppelung gleichzeitig vorteilhaft auf das Ausbilden eines gezielt angeordneten Feuchtepfades für den Feuchtetest ergibt.

Zusammenfassend lassen sich folgende Vorteile der Erfindung feststellen:
1. Die verlängerte oder in der Fläche vergrößerte Klebstofflage entkoppelt mechanisch den Halbleiterchip vom Schaltungssubstrat und gleicht damit die verschiedenen Ausdehnungskoeffizienten aus.
2. Durch gezielte Spaltbildung kann ein Entkopplungspfad geschaffen werden, der auf beabsichtigter Haftverschlechterung zwischen Metalllagen und Gehäusekunststoffmasse basiert.
3. Bei dem erfindungsgemäßen Halbleiterbauteil wird eine erhöhte Thermozyklen-Festigkeit festgestellt.
4. Eine vorteilhafte Pfadbildung für den Feuchtetest wird erreicht.
5. Eine höhere Zuverlässigkeit für die Halbleiterbauteile kann garantiert werden.

Die Erfindung wird nun anhand der beigefügten Figuren näher erläutert.
- Figur 1: zeigt einen schematischen Querschnitt durch ein Halbleiterbauteil.
- Figur 2: zeigt einen schematischen Querschnitt durch ein Halbleiterbauteil einer ersten Ausführungsform der Erfindung.

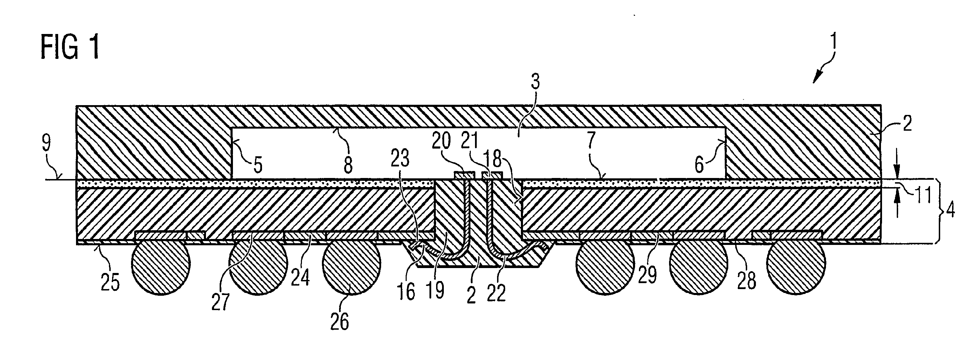

Figur 1 zeigt einen schematischen Querschnitt durch ein Halbleiterbauteil 1. Das Halbleiterbauteil 1 besteht aus zwei Bereichen, die über eine elastische Klebstofflage 11 zusammengehalten werden. Der obere Bereich des Halbleiterbauteils 1 ist auf der Klebstofflage 11 angeordnet und weist einen Halbleiterchip 3 auf, der mit seiner aktiven Oberseite 7 auf der Klebstofflage 11 fixiert ist. Ferner ist auf der Klebstofflage 11 eine Gehäusekunststoffmasse 2 angeordnet, welche die Randseiten 5 und 6 des Halbleiterchips 3 und die Rückseite 8 des Halbleiterchips 3 einbettet. Die Klebstofflage 11 kann aus einer einzigen Klebstoffschicht eines gummielastischen Materials aufgebaut sein, oder aus einer Folie, die beidseitig mit Klebstoff beschichtet ist, bestehen. Die Klebstoffschicht kann auch günstig gedruckt oder dispensiert werden.

Eine Folie, mit beidseitigen Klebstoffschichten als Klebstofflage 11 hat den Vorteil, dass sie für die Herstellung des in Figur 1 gezeigten Bauteils Fertigungsvorteile aufweist, da sie reproduzierbar auf dem Schaltungsträger 4 derart positioniert werden kann, dass eine Öffnung 18 in dem Schaltungsträger 4 frei bleibt. Der zweite Bereich des Halbleiterbauteils 1 wird in einem Schaltungsträger 4 gebildet, der auf seiner Oberseite 9 die Klebstofflage 11 trägt. Auf seiner Rückseite 25 weist der Schaltungsträger 4 eine Umverdrahtungsstruktur 24 auf, die von einer Lotstoplackschicht 28 teilweise bedeckt ist. Die Umverdrahtungsstruktur 24 weist Umverdrahtungsleitungen 29, Außenkontaktflächen 27 und Bondfinger 23 auf.

Die Bondfinger 23 sind in dem Randbereich der zentralen Öffnung 18 auf der Rückseite 25 des Schaltungsträgers 4 angeordnet, während die Außenkontaktflächen 27, die über Umverdrahtungsleitungen 29 mit den Bondfingern 23 verbunden sind, Außenkontakte 26 tragen. Der untere Bereich mit dem Schaltungsträger 4 und der obere Bereich mit dem Halbleiterchip 3 in der Gehäusekunststoffmasse 2 sind über elektrische Verbindungen 16 untereinander elektrisch verbunden. Die elektrischen Verbindungen 16 weisen Bonddrähte 22 auf, die in einem Bondkanal 19 angeordnet sind. Diese Bonddrähte 22 verbinden zwei Reihen von Kontaktflächen 20 und 21 auf der aktiven Oberseite 7 des Halbleiterchips 3 mit den Bondfingern 23 auf der Rückseite 25 des Schaltungsträgers 4.

Die Vorteile einer durchgängigen Klebstofflage 11 für den Zusammenhalt eines derartigen Bauteils 1 wurden oben ausführlich erörtert und werden an dieser Stelle, zur Vermeidung von Wiederholungen, nicht extra diskutiert. Nicht nur der Halbleiterchip 3 ist in der Gehäusekunststoffmasse 2 eingebettet, sondern auch die Bonddrähte 22 sind durch Versiegeln des Bondkanales 19 mit Gehäusekunststoffmasse 2 in eine derartige Kunststoffmasse eingebettet. Auch auf die Erörterung des Verfahrens zur Herstellung eines derartigen Halbleiterbauteils 1 wird an dieser Stelle verzichtet, zumal dieses bereits oben geschildert wurde.

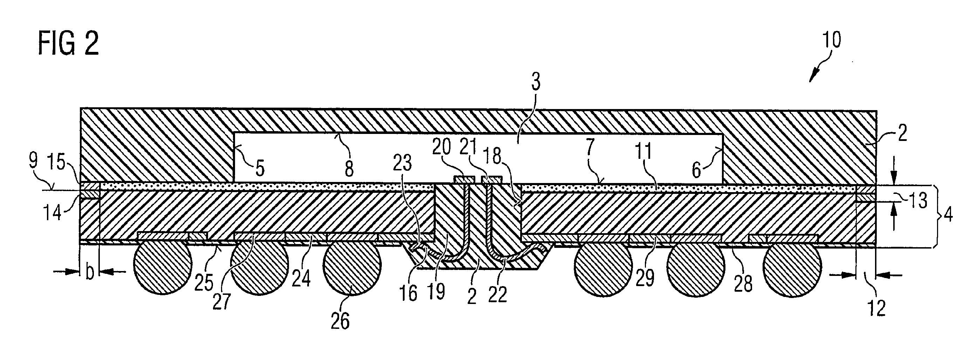

Figur 2 zeigt einen schematischen Querschnitt durch ein Halbleiterbauteil einer ersten Ausführungsform der Erfindung. Komponenten mit gleichen Funktionen, wie in Figur 1, werden mit gleichen Bezugszeichen gekennzeichnet und nicht extra erörtert.

Die erste Ausführungsform der Erfindung gemäß Figur 2 unterscheidet sich vom Bauteil gemäß Figur 1 darin, dass zwischen dem oberen Teil des Halbleiterbauteils 10 und dem unteren Bereich des Halbleiterbauteils 10 in den Randbereichen 12 des Halbleiterbauteils 10 anstelle einer Klebstofflage 11, eine Metalllage 13 angeordnet ist. Diese Metalllage 13 besteht in dieser Ausführungsform der Erfindung aus zwei Komponenten, nämlich einer Kupferlage 14 auf dem Schaltungsträger 4 und einer darauf aufgebrachten Goldslage 15.

Die Breite b der Metalllage 13 ist so bemessen, dass ein sicheres Trennen von mehreren Halbleiterbauteilen 10 aus einem Nutzen entlang von Sägespuren möglich ist, ohne dass eine Klebstofflage 11 das Trennwerkzeug verschmutzen kann. Die Goldbeschichtung sorgt dafür, dass die Haftung der Gehäusekunststoffmasse 2 in der Grenzschicht zwischen dem Material der Gehäusekunststoffmasse 2 und der Goldbeschichtung vermindert ist, so dass sich zusätzlich zu der rein duktilen Nachgiebigkeit der Gold- und Kupferlage 14, 15 der Metalllage 13 auch Mikrospalten in der Grenzschicht bei extremer Belastung ausbilden können, die einerseits einen Feuchtepfad ermöglichen, über den Feuchte aus dem Halbleiterbauteil 10 austreten kann, womit der Feuchtetest verbessert wird und andererseits eine Nachgiebigkeit im Randbereich ermöglichen, womit eine verbesserte Zuverlässigkeit bei Thermozyklusprüfungen erreicht wird.

## Patentansprüche

1. Halbleiterbauteil (10) mit Gehäusekunststoffmasse (2), Halbleiterchip (3) und Schaltungsträger (4), wobei der Halbleiterchip (3) in der Gehäusekunststoffmasse (2) mit einer seiner beiden Oberseiten (7, 8) und seinen Randseiten (5, 6) eingebettet ist und wobei die andere seiner beiden Oberseiten (7, 8) oberflächenmontiert auf einer Oberseite (9) des Schaltungsträgers (4) angeordnet ist, und wobei der nicht von dem Halbleiterchip (3) bedeckte Bereich der Oberseite (9) des Schaltungsträgers (4) von der Gehäusekunststoffmasse (2) bedeckt ist, und wobei auf der Oberseite (9) des Schaltungsträgers (4) eine durchgängige elastische Klebstofflage (11) zwischen Gehäusekunststoffmasse (2) und Schaltungsträgers (4), sowie zwischen Halbleiterchip (3) und Schaltungsträgers (4) angeordnet ist, und wobei Randbereiche (12) des Halbleiterbauteils (1) frei von der elastischen Klebstofflage (11) sind,
**dadurch gekennzeichnet, dass** die von Klebstofflage (11) freigehaltenen Randbereiche (12) des Halbleiterbauteils (1) elastische Metalllagen (13) aufweisen, wobei die Metalllagen (13) eine auf dem Schaltungsträger (4) angeordnete Kupferlage (14) einer Kupferlegierung und eine darauf aufgebrachte Goldlage (15) einer Goldlegierung aufweisen, oder
die Metalllagen (13) eine auf dem Schaltungsträger (4) angeordnete Kupferlage (14) einer Kupferlegierung und eine darauf aufgebrachte Silberlage einer Silberlegierung aufweisen, oder
die Metalllagen (13) eine auf dem Schaltungsträger (4) angeordnete Kupferlage (14) einer Kupferlegierung und eine darauf aufgebrachte Aluminiumlage einer Aluminiumlegierung aufweisen.

2. Verfahren zur Herstellung eines Halbleiterbauteiles nach Anspruch 1, wobei mehrere einzelne Halbleiterbauteile 10 aus einem Nutzen entlang von Sägespuren getrennt werden,
**dadurch gekennzeichnet, dass** die Breite (b) der Metalllagen (13) in den Randbereichen (12) des Halbleiterbauteils (1) an die Breite von den Sägespuren in der Weise angepasst sind, dass bei der Herstellung von Randseiten des Halbleiterbauteils (1) die elastische Klebstofflage (11) keinem Sägevorgang ausgesetzt ist.

## Claims

1. A semiconductor component (10) comprising a synthetic housing material (2), a semiconductor chip (3) and circuit support (4), whereby the semiconductor chip (3) is embedded in the synthetic housing material (2) with one of its two upper sides (7, 8) and its side faces (5, 6) and the other one of its two upper sides (7, 8) is arranged on the upper side (9) of the circuit support (4) in a surface-mounted manner, and whereby the area of the upper side (9) of the circuit support (4) which is not covered by the semiconductor chip (3) is covered by the synthetic housing material (2), and whereby a continuous elastic adhesive layer (11) is arranged on the upper side (9) of the circuit support (4) between the synthetic housing material (2) and the circuit support (4) as well as between the semiconductor chip (3) and the circuit support (2), and whereby the periphery (12) of the semiconductor component (1) are free of the elastic adhesive layer (11),
**characterized in that** the periphery (12) of the semiconductor component (1) which is kept free of adhesive layer (11) comprise elastic metal layers (13), whereby the metal layers (13) comprise a copper layer (14) of a copper alloy arranged on the circuit carrier (4) and a gold layer (15) of a gold alloy arranged thereon, or whereby the metal layers (13) comprise a copper layer (14) of a copper alloy arranged on the circuit carrier (4) and a silver layer (15) of a silver alloy arranged thereon, or
whereby the metal layers (13) comprise a copper layer (14) of a copper alloy arranged on the circuit carrier (4) and an aluminum layer (15) of an aluminum alloy arranged thereon.

2. Method of producing a semiconductor component according to claim 1, whereby a plurality of individual semiconductor components (10) from a batch are separated alongside sawing traces,
**characterized in that** the width (b) of the metal layers (13) in the periphery (12) of the semiconductor component (1) is adapted to the width of the sawing traces in such a way that during the production of the side faces of the semiconductor component (1) the elastic adhesive layer (11) is not subjected to a sawing process.

## Revendications

1. Composant semi-conducteur (10) qui présente une pâte (2) en matière synthétique de boîtier, une puce semi-conductrice (3) et un porte-circuit (4),
la puce semi-conductrice (3) étant incorporée dans la pâte (2) en matière synthétique de boîtier par un de ses deux côtés supérieurs (7, 8) et ses bords latéraux (5, 6), l'autre de ses deux côtés supérieurs (7, 8) étant monté en surface sur le côté supérieur (9) du porte-circuit (4),
la partie du côté supérieur (9) du porte-circuit (4) non recouverte par la puce semi-conductrice (3) étant recouverte par la pâte (2) de matière synthétique de boîtier,
une couche continue (11) d'adhésif élastique étant appliquée sur le côté supérieur (9) du porte-circuit (4) entre la pâte (2) de matière synthétique de boîtier et le porte-circuit (4) ainsi qu'entre la puce semi-conductrice (3) et le porte-circuit (4), des bordures (12) du composant semi-conducteur (1) ne présentant pas la couche (11) d'adhésif élastique,
**caractérisé en ce que**
les bordures (12) du composant semi-conducteur (1) ne présentant pas la couche (11) d'adhésif présentent des couches métalliques élastiques (13), les couches métalliques (13) présentant une couche de cuivre (14) en alliage de cuivre disposées sur le porte-circuit (4) et une couche d'or (15) en alliage d'or appliquée sur elles ou
les couches métalliques (13) présentent une couche de cuivre (14) en alliage de cuivre disposée sur le porte-circuit (4) et par-dessus une couche d'argent en alliage d'argent ou
les couches métalliques (13) présentent une couche de cuivre (14) en alliage de cuivre disposées sur le porte-circuit (4) et par-dessus une couche d'aluminium en alliage d'aluminium.

2. Procédé de fabrication d'un composant semi-conducteur selon la revendication 1, dans lequel plusieurs composants semi-conducteurs (10) distincts sont découpés dans un flan le long de traces de sciage, **caractérisé en ce que** la largeur (b) des couches métalliques (13) des bordures (12) du composant semi-conducteur (1) est adaptée à la largeur des traces de sciage de telle sorte que la couche (11) d'élastique adhésif ne subisse pas l'opération de sciage lors de la fabrication des bords latéraux du composant semi-conducteur (1).
